# EUROPÄISCHE PATENTANMELDUNG

(11) **EP 4 060 099 A1**
(43) Veröffentlichungstag der Anmeldung: **21.09.2022**
(21) Anmeldenummer: 21163803.6
(22) Anmeldetag: 19.03.2021
(51) Int. Cl.: C30B 23/02, C30B 29/36

(54) **HERSTELLUNGSVERFAHREN FÜR EINEN SIC-VOLUMENEINKRISTALL HOMOGENER SCHRAUBENVERSETZUNGSVERTEILUNG UND SIC-SUBSTRAT**

(71) Anmelder: SiCrystal GmbH, 90411 Nürnberg (DE)
(72) Erfinder: Ecker, Bernhard, 90491 Nürnberg (DE); Müller, Ralf, 90513 Zirndorf (DE); Stockmeier, Matthias, 91349 Egloffstein (DE); Vogel, Michael, 90489 Nürnberg (DE); Weber, Arnd-Dietrich, 91301 Forchheim (DE)
(74) Vertreter: Rau, Schneck & Hübner Patentanwälte Rechtsanwälte PartGmbB

(57) **Zusammenfassung**

Das Verfahren ist zur Herstellung mindestens eines SiC-Volumeneinkristalls (2) mittels einer Sublimationszüchtung bestimmt. Vor Züchtungsbeginn wird in einem Kristallwachstumsbereich eines Züchtungstiegels ein SiC-Keimkristall (8) mit einer Wachstumsoberfläche (18) angeordnet und in einen SiC-Vorratsbereich des Züchtungstiegels SiC-Quellmaterial eingebracht. Während der Züchtung wird bei einer Züchtungstemperatur von bis zu 2400°C und einem Züchtungsdruck zwischen 0,1 mbar und 100 mbar mittels Sublimation des SiC-Quellmaterials und mittels Transport der sublimierten gasförmigen Komponenten in den Kristallwachstumsbereich dort eine SiC-Wachstumsgasphase erzeugt, in der mittels Abscheidung aus der SiC-Wachstumsgasphase auf dem SiC-Keimkristall (8) ein SiC-Volumeneinkristall (2) aufwächst. Vor Züchtungsbeginn wird der SiC-Keimkristall (8) an der Wachstumsoberfläche (18) auf das Vorhandensein von Keim-Schraubenversetzungen (20) untersucht, wobei die Wachstumsoberfläche (18) in Keimsegmente aufgeteilt wird und für jedes Keimsegment eine zugehörige lokale Schraubenversetzungs-Keimsegmentdichte ermittelt wird, und bearbeitet, so dass in jedem Keimsegment, dessen lokale Schraubenversetzungs-Keimsegmentdichte um mindestens einen Faktor von 1,5 bis 4 über einer für die gesamte Wachstumsoberfläche (18) ermittelten Schraubenversetzungs-Keimgesamtdichte liegt, Nukleationszentren (22) generiert werden, wobei die Nukleationszentren (22) während der danach durchgeführten Züchtung Ausgangspunkte für jeweils mindestens eine Kompensations-Schraubenversetzung sind.

## Beschreibung

Die Erfindung betrifft ein Verfahren zur Herstellung mindestens eines SiC-Volumeneinkristalls mittels einer Sublimationszüchtung sowie ein einkristallines SiC-Substrat.

Das Halbleitermaterial Siliziumcarbid (SiC) wird aufgrund seiner herausragenden physikalischen, chemischen, elektrischen und optischen Eigenschaften unter anderem auch als Ausgangsmaterial für leistungselektronische Halbleiterbauelemente, für Hochfrequenzbauelemente und für spezielle lichtgebende Halbleiterbauelemente eingesetzt. Für diese Bauelemente werden SiC-Substrate (= SiC-Wafer) mit möglichst großem Substratdurchmesser und möglichst hoher Qualität benötigt.

Basis für die SiC-Substrate sind hochwertige SiC-Volumeneinkristalle, die in der Regel mittels physikalischer Gasphasenabscheidung (PVT) hergestellt werden, insbesondere mittels eines z.B. in der US 8,865,324 B2 beschriebenen (Sublimations-)Verfahrens. Bei diesem Züchtungsverfahren wird eine einkristalline SiC-Scheibe als SiC-Keimkristall zusammen mit geeignetem Quellmaterial in einen Züchtungstiegel eingebracht. Unter kontrollierten Temperatur- und Druckbedingungen wird das Quellmaterial sublimiert und die gasförmigen Spezies scheiden sich auf dem SiC-Keimkristall ab, so dass der SiC-Volumeneinkristall dort aufwächst.

Aus dem SiC-Volumeneinkristall werden anschließend z.B. mit Hilfe einer Fadensäge scheibenförmige einkristalline SiC-Substrate herausgeschnitten, die nach einer mehrstufigen veredelnden Bearbeitung ihrer Oberfläche, insbesondere mittels mehrerer Polierschritte, im Rahmen der Bauelementefertigung mit mindestens einer dünnen einkristallinen Epitaxieschicht z.B. aus SiC oder GaN (Galliumnitrid) versehen werden. Die Eigenschaften dieser Epitaxieschicht und damit letztlich auch die der daraus hergestellten Bauelemente hängen entscheidend von der Qualität des SiC-Substrats bzw. des zugrundeliegenden SiC-Volumeneinkristalls ab.

Für die Herstellung der epitaktischen Schichten sind unter anderem auch im SiC-Substrat gegebenenfalls vorhandene Schraubenversetzungen (engl.: "threading screw dislocation", abgekürzt als TSD) von Bedeutung, da sich die Schraubenversetzungen in die epitaktische Schicht fortpflanzen können, was eine reduzierte Qualität und/oder Ausbeute der daraus gefertigten elektronischen Bauelemente zur Folge haben kann. Für eine hohe Ausbeute sollten Kristalldefekte, wie z.B. Schraubenversetzungen, die während des Kristallwachstums durch Abweichungen von der idealen Kristallform entstehen können, weitestgehend vermieden werden. Weiterhin ist die Herstellung von SiC-Volumeneinkristallen durch den PVT-Prozess sehr kosten- und zeitintensiv. Material, das z.B. durch eine versetzungsbedingte unvollkommene Kristallstruktur für die Weiterverwendung zur Bauelementeherstellung unbrauchbar ist, führt deshalb zu stark verringerten Ausbeuten und erhöhten Kosten.

In der US 9,234,297 B2 wird ein Verfahren beschrieben, welches auf einem zweistufigen Züchtungsprozess basiert, wobei in einer ersten Züchtungsstufe bei niedriger Wachstumsgeschwindigkeit und erhöhtem Druck Schraubenversetzungen im Randbereich des aufwachsenden SiC-Volumeneinkristalls in Stapelfehler umgewandelt werden, die dann senkrecht zur Wachstumsrichtung nach außen wachsen. In der sich anschließenden zweiten Züchtungsstufe wird die Wachstumsgeschwindigkeit (bei abgesenktem Druck) erhöht und der ab dann aufwachsende SiC-Volumeneinkristall hat im Randbereich ein Kristallvolumen mit einer reduzierten Anzahl von Schraubenversetzungen. Allerdings genügt eine niedrige Schraubenversetzungsdichte nur im Randbereich nicht aus, um elektronische Bauelemente auf SiC-Substraten wirtschaftlich herstellen zu können. Daher ist weitere Reduzierung der Schraubenversetzungsdichte wünschenswert.

Die Aufgabe der Erfindung besteht darin, ein gegenüber den bekannten Lösungen verbessertes Verfahren zur Herstellung eines SiC-Volumeneinkristalls sowie ein verbessertes einkristallines SiC-Substrat anzugeben.

Zur Lösung der das Verfahren betreffenden Aufgabe wird ein Verfahren entsprechend den Merkmalen des Patentanspruchs 1 angegeben. Bei dem erfindungsgemäßen Verfahren handelt es sich um ein solches zur Herstellung mindestens eines SiC-Volumeneinkristalls mittels einer Sublimationszüchtung, wobei vor Züchtungsbeginn in einem Kristallwachstumsbereich eines Züchtungstiegels ein SiC-Keimkristall mit einer Wachstumsoberfläche angeordnet wird und in einen SiC-Vorratsbereich des Züchtungstiegels SiC-Quellmaterial, insbesondere pulverförmiges oder insbesondere verdichtetes, bevorzugt zumindest teilweise verdichtetes SiC-Quellmaterial oder insbesondere SiC-Quellmaterial in Form eines einkristallinen oder polykristallinen Festkörperblocks, bevorzugt mit einer Dichte von 3,0 g/cm² bis 3,21 g/cm², oder insbesondere eine Kombination aus diesen verschiedenen SiC-Quellmaterialien, eingebracht wird. Während der Züchtung wird bei einer, insbesondere an einer Wachstumsgrenzfläche des aufwachsenden SiC-Volumeneinkristalls herrschenden, Züchtungstemperatur von bis zu 2400°C und einem Züchtungsdruck zwischen 0,1 mbar und 100 mbar mittels Sublimation des SiC-Quellmaterials und mittels Transport der sublimierten gasförmigen Komponenten in den Kristallwachstumsbereich dort eine SiC-Wachstumsgasphase erzeugt, in der mittels Abscheidung aus der SiC-Wachstumsgasphase auf dem SiC-Keimkristall ein SiC-Volumeneinkristall aufwächst. Dabei wird der SiC-Keimkristall vor Züchtungsbeginn an der Wachstumsoberfläche auf das Vorhandensein von Keim-Schraubenversetzungen untersucht, wobei die Wachstumsoberfläche in Keimsegmente aufgeteilt wird und für jedes Keimsegment eine zugehörige lokale Schraubenversetzungs-Keimsegmentdichte ermittelt wird. Weiterhin wird der SiC-Keimkristall vor Züchtungsbeginn an der Wachstumsoberfläche bearbeitet, so dass in jedem Keimsegment, dessen lokale Schraubenversetzungs-Keimsegmentdichte um mindestens einen Faktor von 1,5 bis 4, und insbesondere um mindestens einen Faktor von 2, über einer für die gesamte Wachstumsoberfläche ermittelten Schraubenversetzungs-Keimgesamtdichte liegt, Nukleationszentren generiert werden, wobei die Nukleationszentren während der danach durchgeführten Züchtung (insbesondere mögliche) Ausgangspunkte für jeweils mindestens eine Kompensations-Schraubenversetzung sind.

Die Keimsegmente können jeweils insbesondere rund, quadratisch oder rechteckig sein und jeweils eine Keimsegmentfläche von vorzugsweise 1 mm² bis 100 mm², bevorzugt 5 mm² oder 10 mm² haben. Auch andere Keimsegmentgeometrien sind möglich. Vorzugsweise sind die Keimsegmentgeometrien und/oder die Keimsegmentflächen aller Keimsegmente jeweils gleich. Ausnahmen hiervon können beispielsweise für die am Rand des SiC-Keimkristalls liegenden Keimsegmente gelten. Prinzipiell können die Keimsegmente aber auch ansonsten voneinander abweichende, insbesondere auch beliebig voneinander abweichende, Keimsegmentgeometrien und/oder Keimsegmentflächen haben.

Die Schraubenversetzungs-Keimgesamtdichte kann dabei insbesondere dadurch ermittelt werden, dass die Anzahl aller an der gesamten Wachstumsoberfläche des SiC-Keimkristalls ermittelten Keim-Schraubenversetzungen auf die Gesamtfläche dieser Wachstumsoberfläche bezogen wird. Alternativ kann die Schraubenversetzungs-Keimgesamtdichte insbesondere auch als arithmetischer Mittelwert der lokalen Schraubenversetzungs-Keimsegmentdichten aller Keimsegmente der Wachstumsoberfläche ermittelt werden. Die Schraubenversetzungs-Keimgesamtdichte kann insofern insbesondere auch als globale und/oder mittlere Schraubenversetzungs-Keimdichte bezeichnet werden.

Unter einer Schraubenversetzung wird hier sowohl eine reine Schraubenversetzung als auch eine der Mischformen, die zumindest auch eine Komponente in m- oder α-Kristallrichtung haben, verstanden.

Jedes Nukleationszentrum kann, muss aber nicht, ein tatsächlicher Ausgangspunkt für eine sich während der nachfolgend durchgeführten KristallZüchtung ausbildende Kompensations-Schraubenversetzung sein. Insbesondere bildet sich an einem Nukleationszentrum genau eine solche Kompensations-Schraubenversetzung aus. Es ist aber auch möglich, dass ein Nukleationszentrum Ausgangspunkt für mehr als eine Kompensations-Schraubenversetzung ist. Insbesondere werden für alle festgestellten Keim-Schraubenversetzungen Nukleationszentren erzeugt.

Vorteilhafterweise werden die Nukleationszentren dort erzeugt, wo bei der vorangegangenen insbesondere segmentweisen Untersuchung eine erhöhte lokale Schraubenversetzungs-Keimsegmentdichte festgestellt worden ist.

Es wurde erkannt, dass eine Hauptursache für eine lokal erhöhte Schraubenversetzungsdichte im aufwachsenden SiC-Volumeneinkristall (und damit auch in den daraus später hergestellten scheibenförmigen SiC-Substraten) der zur Züchtung verwendete SiC-Keimkristall ist. So können sich im SiC-Keimkristall vorhandene Keim-Schraubenversetzungen während des Züchtungsvorgangs in Wachstumsrichtung in den wachsenden SiC-Volumeneinkristall fortpflanzen. Um dies zu vermeiden, wird die Wachstumsoberfläche des SiC-Keimkristalls bearbeitet und dabei mit den gezielt ein- oder aufgebrachten Nukleationszentren versehen. Diese Nukleationszentren sind zu Beginn eines Züchtungsprozesses insbesondere Ausgangspunkte für zusätzliche Schraubenversetzungen, nämlich den Kompensations-Schraubenversetzungen. Eine solche von einem gezielt platzierten Nukleationszentrum ausgehende Kompensations-Schraubenversetzung kann dann mit der sich am Ort des Nukleationszentrums aus dem SiC-Keimkristall fortsetzenden Schraubenversetzung vorzugsweise rekombinieren.

Durch Wechselwirkung der aus dem SiC-Keimkristall stammenden Schraubenversetzungen mit den an Nukleationszentren, z.B. an deren artifiziellen Oberflächenstrukturen, nukleierten Schraubenversetzungen (= Kompensations-Schraubenversetzungen) können diese Schraubenversetzungen rekombinieren und ausgelöscht werden. Diese vorteilhafte Rekombination tritt insbesondere dann auf, wenn es sich um Schraubenversetzungen mit unterschiedlicher Drehrichtung, d.h. mit unterschiedlichem Vorzeichen des jeweiligen Burgers-Vektors, handelt. Da im SiC-Keimkristall das Verhältnis der Anzahl von Schraubenversetzungen mit positivem Burgers-Vektor zu der Anzahl von Schraubenversetzungen mit negativem Burgers-Vektor üblicherweise bei nahezu 1 liegt, können durch die gezielt hervorgerufenen Kompensations-Schraubenversetzungen beide Anteile im wachsenden SiC-Volumeneinkristall reduziert werden. Dies gilt insbesondere an den Positionen, an denen im SiC-Keimkristall bei der Untersuchung eine erhöhte lokale Schraubenversetzungs-Keimsegmentdichte festgestellt worden ist, und an denen dementsprechend gezielt Nukleationszentren gebildet worden sind.

Neben dem vorstehend beschriebenen Mechanismus zur Erzeugung von Kompensations-Schraubenversetzungen können durch die Bearbeitung, insbesondere Strukturierung, der Wachstumsoberfläche des SiC-Keimkristalls in Verbindung mit dem beginnenden Kristallzüchtungsprozess zusätzlich mikroskopische innere Oberflächen erzeugt werden. Auch letztere können Ausgangspunkte für unter anderem zusätzliche Schraubenversetzungen mit positiven oder negativen Burgers-Vektoren sein, die dann vorteilhafterweise ebenfalls als Kompensations-Schraubenversetzungen zur Reduktion der (erhöhten lokalen) Schraubenversetzungsdichte beitragen können.

Die miteinander rekombinierenden Schraubenversetzungen löschen sich also vorzugsweise gegenseitig aus und sind in der Kristallstruktur des aufwachsenden SiC-Volumeneinkristalls ab der Rekombinationsstelle nicht mehr vorhanden. Damit reduziert sich die Schraubenversetzungsdichte im aufwachsenden SiC-Volumeneinkristall, sowohl lokal als auch insgesamt betrachtet. Außerdem kommt es im aufwachsenden SiC-Volumeneinkristall zu einer Vereinheitlichung der Verteilung der Schraubenversetzungen. Die noch verbleibenden Schraubenversetzungen sind dann radial oder lateral (d.h. innerhalb einer senkrecht zur Wachstumsrichtung orientierten Querschnittsfläche des aufwachsenden SiC-Volumeneinkristalls; die Wachstumsrichtung des aufwachsenden SiC-Volumeneinkristalls wird dagegen auch als axiale Richtung verstanden) vorzugsweise sehr homogen verteilt angeordnet.

Mit dem erfindungsgemäßen Verfahren lässt sich Schraubenversetzungsdichte im aufwachsenden SiC-Volumeneinkristall (und damit auch in den daraus später hergestellten scheibenförmigen SiC-Substraten) vorzugsweise überall und nicht nur z.B. im Randbereich reduzieren und insbesondere auch homogenisieren. Dies ist ein Vorteil gegenüber den bisher bekannten Verfahren.

Die Untersuchung und Bearbeitung des SiC-Keimkristalls vor Züchtungsbeginn erfolgt insbesondere vor dem Einsetzen des SiC-Keimkristalls in den Züchtungstiegel. Im Rahmen der Untersuchung wird der SiC-Keimkristall vor Verwendung im Züchtungsprozess hinsichtlich seiner Keim-Schraubenversetzungen charakterisiert. Insbesondere werden Keimsegmente mit erhöhter lokaler Schraubenversetzungs-Keimsegmentdichte definiert (= ermittelt) und insbesondere auch markiert, um die Bearbeitung zur Erzeugung der Nukleationszentren an der richtigen Stelle durchzuführen. Die Markierung erfolgt insbesondere mittels Verwendung einer x-y-Bühne, die eine genaue Positionierung des untersuchten SiC-Keimkristalls in den beiden zueinander senkrecht stehenden lateralen Richtungen (= x- und y-Richtung) erlaubt. Die x-Koordinate und die y-Koordinate eines Keimsegments mit erhöhter lokaler Schraubenversetzungs-Keimsegmentdichte werden bestimmt und gespeichert.

Insgesamt können mit dem erfindungsgemäßen Züchtungsverfahren SiC-Volumeneinkristalle hergestellt werden, aus denen sich hochqualitative SiC-Substrate gewinnen lassen. Solche SiC-Substrate mit hoher Genauigkeit in ihrer SiC-Kristallstruktur bieten nahezu ideale Bedingungen für die im Rahmen der Bauelementeherstellung durchzuführenden Folgeprozessschritte. Erfindungsgemäß hergestellte SiC-Volumeneinkristalle lassen sich also sehr effizient weiterverwenden, insbesondere zur Herstellung von Halbleiter- und/oder Hochfrequenzbauelementen.

Mit dem erfindungsgemäßen Verfahren kann ein einziger SiC-Volumeneinkristall, aber auch eine größere Anzahl, beispielsweise zwei, drei, vier, fünf oder auch vorzugsweise bis zu zehn SiC-Volumeneinkristalle, hergestellt werden. Günstig ist ein Verfahren, bei dem zwei insbesondere in Richtung der Mittenlängsachse über- oder hintereinander angeordnete SiC-Volumeneinkristalle gezüchtet werden, die in Richtung der Mittenlängsachse betrachtet auf beiden Seiten des SiC-Vorratsbereichs aufwachsen.

Vorteilhafte Ausgestaltungen des erfindungsgemäßen Verfahrens ergeben sich aus den Merkmalen der von Anspruch 1 abhängigen Ansprüche.

Günstig ist eine Ausgestaltung, bei der in einem, insbesondere in jedem, Keimsegment mit festgestellter erhöhter lokaler Schraubenversetzungs-Keimsegmentdichte eine Nukleations-Anzahl an Nukleationszentren generiert wird, welche mindestens halb so groß ist wie eine Versetzungs-Anzahl an in diesem Keimsegment ermittelten Keim-Schraubenversetzungen. Insbesondere liegt das Verhältnis der Nukleations-Anzahl zu der Versetzungs-Anzahl im Bereich zwischen 0,5 und 1. Dadurch wird erreicht, dass für möglichst viele, bevorzugt für alle, der ermittelten Keim-Schraubenversetzungen ein Ausgangspunkt für eine sich im später auf dem Keimkristall aufwachsenden SiC-Volumeneinkristall ausbildende Kompensations-Schraubenversetzung vorhanden ist.

Gemäß einer weiteren günstigen Ausgestaltung werden die Nukleationszentren durch eine lokal begrenzte, insbesondere zusätzlich vorgenommene, Strukturierung der Wachstumsoberfläche generiert. Die Strukturierung kann dabei insbesondere durch Materialabtrag und/oder Materialauftrag erfolgen. Durch eine gezielte Strukturierung der Wachstumsoberfläche, wie z.B. durch eine lokale Erzeugung von einem oder mehreren Kratzern und/ oder durch eine lokal begrenzte Ätzung, lässt sich ein Nukleationszentrum und damit ein möglicher Ausgangspunkt für eine Kompensations-Schraubenversetzung sehr einfach und sehr effizient bilden. An solchen gezielt erzeugten Strukturen der Wachstumsoberfläche des SiC-Keimkristalls nukleieren Kompensations-Schraubenversetzungen besonders gut, insbesondere gleich zu Beginn eines Züchtungsprozesses. Durch die Strukturierung wird die Wachstumsoberfläche am Ort der Strukturierung insbesondere aufgeraut. In einem so strukturierten Bereich hat die Wachstumsoberfläche vorzugsweise eine zwei- bis dreifach höhere Rauigkeit verglichen mit unstrukturierten Bereichen, in denen keine Keim-Schraubenversetzungen an der Wachstumsoberfläche des SiC-Keimkristalls festgestellt worden sind und in denen eine Rauigkeit von insbesondere Ra ≤ 0,4 nm gegeben ist. Die Oberflächenrauigkeit in zur Ausbildung von Nukleationszentren gezielt strukturierten Bereichen der Wachstumsoberfläche des SiC-Keimkristalls wird also insbesondere um einen Faktor 2 bis 3 größer als in unstrukturierten Bereichen der Wachstumsoberfläche des SiC-Keimkristalls eingestellt.

Gemäß einer weiteren günstigen Ausgestaltung werden die Nukleationszentren durch eine lokal begrenzte Behandlung oder Bearbeitung der Wachstumsoberfläche mit einer Laserstrahlung generiert. Mittels der Laserstrahlung wird üblicherweise eine insbesondere materialabtragende, manchmal und bei Bedarf aber auch eine materialauftragende Strukturierung der Wachstumsoberfläche vorgenommen. Mittels Laserstrahlung lässt sich die Wachstumsoberfläche sehr einfach so strukturieren, dass Nukleationszentren gebildet werden.

Gemäß einer weiteren günstigen Ausgestaltung werden die Nukleationszentren durch eine lokal begrenzte, insbesondere lithographische, Beschichtung der Wachstumsoberfläche mit einem Zusatzstoff generiert. Durch die Beschichtung mit dem Zusatzstoff wird insbesondere eine materialauftragende Strukturierung der Wachstumsoberfläche durchgeführt. Als Zusatzstoff für die lokal begrenzte Beschichtung der Wachstumsoberfläche wird mindestens ein Material aus der Gruppe von Kohlenstoff (C), Siliziumdioxid (SiO₂), Graphit und Graphen verwendet.

Gemäß einer weiteren günstigen Ausgestaltung werden die Nukleationszentren durch ein lokal begrenztes Polieren der Wachstumsoberfläche generiert. Durch das Polieren wird insbesondere eine materialabtragende Strukturierung der Wachstumsoberfläche durchgeführt. Bevorzugt wird das lokal begrenzte Polieren mittels einer Diamantsuspension und/oder mittels eines chemo-mechanischen Polierverfahrens, welches vorzugsweise ist, durchgeführt. Das chemo-mechanische Polierverfahren wird dabei vorzugsweise defekt- oder TSD-selektiv durchgeführt, also insbesondere nur an solchen Stellen, an denen sich eine Keim-Schraubenversetzung an der Wachstumsfläche des SiC-Keimkristalls befindet. Im Rahmen des Polierens ist es insbesondere auch möglich, eine lokal höhere Oberflächenrauigkeit einzustellen, beispielsweise dadurch, dass der entsprechende Bereich nachträglich nochmals mit einer grobkörnigeren Polierpaste behandelt (und damit wieder aufgeraut) oder bei der End-Behandlung mit feinkörnigeren Polierpasten ausgespart wird.

Gemäß einer weiteren günstigen Ausgestaltung werden die Nukleationszentren durch ein lokal begrenztes Ätzen der Wachstumsoberfläche generiert. Durch das Ätzen wird insbesondere eine materialabtragende Strukturierung der Wachstumsoberfläche durchgeführt. Auch das Ätzen wird dabei vorzugsweise defekt- oder TSD-selektiv durchgeführt, also insbesondere nur an solchen Stellen, an denen sich eine Keim-Schraubenversetzung an der Wachstumsfläche des SiC-Keimkristalls befindet.

Gemäß einer weiteren günstigen Ausgestaltung wird zur Generierung der Nukleationszentren an der Wachstumsoberfläche des SiC-Keimkristalls eine Nano-Struktur erzeugt. Die erzeugte Nano-Struktur hat in Dicken- oder Höhenrichtung insbesondere eine geometrische Ausdehnung im Bereich von einem Nanometer (1 nm) bis zu einigen wenigen Nanometern, vorzugsweise bis zu 10 nm, wobei grundsätzlich aber auch noch dickere Nanostrukturen möglich sind. Die tatsächliche Dicke der Nano-Struktur hängt insbesondere auch davon ab, welches Verfahren zur Herstellung dieser Nano-Struktur zur Anwendung kommt.

Die vorstehend erläuterten Ausgestaltungen zur Generierung der Nukleationszentren an der Wachstumsoberfläche des SiC-Keimkristalls können vorzugsweise auch miteinander kombiniert werden.

Gemäß einer weiteren günstigen Ausgestaltung wird die Untersuchung auf Keim-Schraubenversetzungen röntgentopographisch durchgeführt. Die Röntgentopographie ist eine kommerziell verfügbare und vorteilhafterweise auch zerstörungsfreie Messmethode, die es erlaubt, die Wachstumsoberfläche des SiC-Keimkristalls vollflächig auf das Vorhandensein von Keim-Schraubenversetzungen und deren Verteilung zu prüfen.

Gemäß einer weiteren günstigen Ausgestaltung werden die Untersuchung auf Keim-Schraubenversetzungen und die Bearbeitung der Wachstumsoberfläche des SiC-Keimkristalls zur Generierung der Nukleationszentren in einem kombinierten Verfahren durchgeführt. Bei diesem kombinierten Verfahren werden die Untersuchung auf Keim-Schraubenversetzungen und die Bearbeitung der Wachstumsoberfläche gleichzeitig (= parallel) durchgeführt. Dies ist zeit- und kostensparend. Grundsätzlich können die beiden Verfahrensschritte aber auch sequentiell, also zeitlich nacheinander, durchgeführt werden.

Zur Lösung der das SiC-Substrat betreffenden Aufgabe wird ein SiC-Substrat entsprechend den Merkmalen des Anspruchs 11 angegeben. Bei dem erfindungsgemäßen einkristallinen SiC-Substrat handelt es sich um ein solches, das aus einem sublimationsgezüchteten SiC-Volumeneinkristall hergestellt ist und eine Gesamt-Hauptoberfläche hat, wobei die Gesamt-Hauptoberfläche fiktiv in Substratsegmente mit einer jeweils zugehörigen Substratsegmentfläche aufgeteilt ist, und wobei jedes Substratsegment eine lokale Schraubenversetzungs-Substratsegmentdichte hat, die die Anzahl der in diesem Substratsegment vorhandenen, und insbesondere an der Gesamt-Hauptoberfläche erfassbaren, Substrat-Schraubenversetzungen bezogen auf die Substratsegmentfläche dieses Substratsegments angibt. Weiterhin weist das SiC-Substrat eine für die Gesamt-Hauptoberfläche insgesamt geltende Schraubenversetzungs-Substratgesamtdichte auf. Das SiC-Substrat weist außerdem eine durch mindestens 85 % der Gesamt-Hauptoberfläche gebildete Teilfläche auf, wobei die lokalen Schraubenversetzungs-Substratsegmentdichten aller innerhalb der Teilfläche liegenden Substratsegmente um höchstens 25 % von der Schraubenversetzungs-Substratgesamtdichte abweichen.

Die fiktiven Substratsegmente können jeweils insbesondere rund, quadratisch oder rechteckig sein und jeweils eine Substratsegmentfläche von vorzugsweise 1 mm² bis 100 mm², bevorzugt 5 mm² oder 10 mm² haben. Auch andere Substratsegmentgeometrien sind möglich. Vorzugsweise sind die Substratsegmentgeometrien und/oder die Substratsegmentflächen aller Substratsegmente jeweils gleich. Ausnahmen hiervon können beispielsweise für die am Rand des SiC-Substrats liegenden Substratsegmente gelten. Prinzipiell können die Substratsegmente aber auch ansonsten voneinander abweichende, insbesondere auch beliebig voneinander abweichende, Substratsegmentgeometrien und/oder Substratsegmentflächen haben.

Die Schraubenversetzungs-Substratgesamtdichte kann dabei insbesondere dadurch ermittelt werden, dass die Anzahl aller an der gesamten Gesamt-Hauptoberfläche des SiC-Substrats vorhandenen und/oder erfassbaren Substrat-Schraubenversetzungen auf den Flächenwert dieser Gesamt-Hauptoberfläche bezogen wird. Alternativ kann die Schraubenversetzungs-Substratgesamtdichte insbesondere auch als arithmetischer Mittelwert der lokalen Schraubenversetzungs-Substratsegmentdichten aller Substratsegmente der Gesamt-Hauptoberfläche ermittelt werden. Die Schraubenversetzungs-Substratgesamtdichte kann insofern insbesondere auch als globale und/oder mittlere Schraubenversetzungs-Substratdichte bezeichnet werden.

Die durch mindestens 85 % der Gesamt-Hauptoberfläche gebildete Teilfläche kann insbesondere zusammenhängend sein und beispielsweise das Zentrum oder den Randbereich enthalten. Sie kann aber auch nicht zusammenhängend ausgebildet sein. Diese Teilfläche hat vorteilhafterweise eine sehr homogene Verteilung an Substrat-Schraubenversetzungen und eignet sich deshalb besonders gut für Herstellung von elektronischen Bauelementen.

Für eine hochwertige Bauelemente-Herstellung mit hoher Ausbeute ist im Rahmen der epitaktischen Beschichtung eines SiC-Substrats neben einer niedrigen Anzahl von Substrat-Schraubenversetzungen im SiC-Substrat insbesondere auch deren lateral möglichst homogene Verteilung von großer Bedeutung, da sich die Substrat-Schraubenversetzungen in die epitaktische Schicht fortpflanzen können. So kann z.B. eine hohe Anzahl von Schraubenversetzungen auf engem Raum (also eine hohe lokale Schraubenversetzungsdichte) zur Reduzierung der lokalen Ladungsträgerlebensdauer und zur Reduzierung der Durchbruchspannung in daraus hergestellten elektronischen Bauelementen führen. Werden SiC-Substrate mit inhomogenen, lokal erhöhten Schraubenversetzungsdichten eingesetzt, führt das zu geringerer Qualität bzw. geringerer Ausbeute der daraus gefertigten elektronischen Bauelemente. Trotz dieser negativen Auswirkungen ist bei bekannten Lösungen eine lateral inhomogene Verteilung der Substrat-Schraubenversetzungen in SiC-Substraten vorhanden, was so z.B. aus der US 2006/0073707 A1 hervorgeht.

Bei erfindungsgemäßen SiC-Substraten tritt diese Problematik dagegen nicht auf. Sie haben insbesondere eine niedrige Schraubenversetzungsdichte und vorzugsweise auch eine weitgehend homogene laterale Verteilung der verbleibenden Substrat-Schraubenversetzungen, d.h. eine weitgehend homogene Schraubenversetzungsverteilung über die sehr große Teilfläche hinweg, und vorzugsweise auch über die vollständige Gesamt-Hauptoberfläche des SiC-Substrats hinweg.

Das erfindungsgemäße SiC-Substrat erfüllt die industriellen Anforderungen bezüglich eines Einsatzes zur Herstellung von Halbleiterbauelementen. Eine senkrecht zur Gesamt-Hauptoberfläche gemessene Substratdicke eines solchen SiC-Substrats liegt insbesondere im Bereich zwischen etwa 100 µm und etwa 1000 µm und vorzugsweise im Bereich zwischen etwa 200 µm und etwa 500 µm, wobei die Substratdicke eine über die komplette Gesamt-Hauptoberfläche betrachtete globale Dickenschwankung von vorzugsweise höchstens 20 µm aufweist. Das SiC-Substrat hat eine gewisse mechanische Stabilität und ist insbesondere selbsttragend. Es hat bevorzugt eine im Wesentlichen runde Scheibenform, d.h. die Gesamt-Hauptoberfläche ist praktisch rund. Gegebenenfalls kann aufgrund mindestens einer am Umfangsrand vorgesehenen Kennzeichnungsmarkierung eine geringfügige Abweichung von der exakt kreisrunden Geometrie vorliegen. Diese Kennzeichnungsmarkierung kann ein Flat oder ein Notch sein. Das SiC-Substrat ist insbesondere dadurch aus einem sublimationsgezüchteten SiC-Volumeneinkristall, beispielsweise aus einem nach dem vorstehend beschriebenen erfindungsgemäßen Herstellungsverfahren gezüchteten SiC-Volumeneinkristall, hergestellt, dass es als Scheibe senkrecht zu einer Mittenlängsachse des SiC-Volumeneinkristalls abgeschnitten worden ist.

Ansonsten bieten das erfindungsgemäße SiC-Substrat und seine günstigen Varianten im Wesentlichen die gleichen Vorteile, die bereits im Zusammenhang mit dem erfindungsgemäßen Herstellungsverfahren und dessen günstigen Varianten beschrieben worden sind.

Weitere vorteilhafte Ausgestaltungen des erfindungsgemäßen SiC-Substrats ergeben sich aus den Merkmalen der von Anspruch 11 abhängigen Ansprüche.

Günstig ist eine Ausgestaltung, bei der die lokalen Schraubenversetzungs-Substratsegmentdichten aller innerhalb der Teilfläche liegenden Substratsegmente um höchstens 20 %, insbesondere um höchstens 15 %, von der Schraubenversetzungs-Substratgesamtdichte abweichen. Damit ergibt sich eine noch größere günstige Homogenität der Schraubenversetzungsverteilung.

Gemäß einer weiteren günstigen Ausgestaltung hat die Teilfläche eine Größe von mindestens 90 % der Gesamt-Hauptoberfläche. Damit hat ein noch größerer Anteil der Gesamt-Hauptoberfläche eine vorteilhafte hohe laterale Homogenität der Schraubenversetzungsverteilung. Ein noch größerer Teil des SiC-Substrats kann dann für die Herstellung hochwertiger Bauelemente verwendet werden.

Gemäß einer weiteren günstigen Ausgestaltung beträgt die Schraubenversetzungs-Substratgesamtdichte des SiC-Substrats höchstens 1000 cm⁻², insbesondere höchstens 500 cm⁻². Dies sind sehr niedrige Werte für die Schraubenversetzungsdichte, so dass sich das SiC-Substrat auch insofern sehr gut für einen Einsatz bei der Herstellung hochwertiger Bauelemente eignet.

Gemäß einer weiteren günstigen Ausgestaltung unterscheiden sich die lokalen Schraubenversetzungs-Substratsegmentdichten zweier beliebiger innerhalb der Teilfläche liegender und zueinander benachbarter Substratsegmente um höchstens 25 %, insbesondere um höchstens 20 % und vorzugsweise um höchstens 15 %, voneinander. Damit haben benachbarte Substratsegmente sehr ähnliche Werte für ihre jeweiligen lokalen Schraubenversetzungs-Substratsegmentdichten. Die Substrat-Schraubenversetzungen sind somit sehr homogen innerhalb des SiC-Substrats verteilt.

Gemäß einer weiteren günstigen Ausgestaltung hat die Gesamt-Hauptoberfläche (und damit insbesondere auch das SiC-Substrat insgesamt) einen Substratdurchmesser von mindestens 150 mm, insbesondere von mindestens 200 mm. Bevorzugt liegt der Substratdurchmesser bei etwa 200 mm. Eine derzeit fertigungsbedingte Obergrenze des Substratdurchmessers liegt insbesondere bei 250 mm, wobei grundsätzlich aber auch noch größere Substratdurchmesser denkbar sind. Je größer der Substratdurchmesser ist, umso effizienter kann das einkristalline SiC-Substrat beispielsweise zur Herstellung von Halbleiter- und/oder Hochfrequenzbauelementen weiterverwendet werden. Dadurch sinken die Bauelemente-Herstellungskosten. Ein SiC-Substrat mit einem so großen Durchmesser kann mit Vorteil außerdem auch zur Herstellung von relativ großen Halbleiter- und/oder Hochfrequenzbauelementen, die z.B. eine Grundfläche von etwa 1 cm² haben, verwendet werden.

Gemäß einer weiteren günstigen Ausgestaltung hat das SiC-Substrat eine SiC-Kristallstruktur mit nur einem einzigen SiC-Polytyp, insbesondere mit einem der SiC-Polytypen 4H, 6H, 15R und 3C. Bevorzugt liegt eine hohe Modifikationsstabilität vor, die sich insbesondere durch die weitest gehende Abwesenheit von Polytypwechseln auszeichnet. Wenn das SiC-Substrat nur einen einzigen SiC-Polytyp aufweist, hat es vorteilhafterweise auch nur eine sehr geringe Defektdichte. Es resultiert eine qualitativ sehr hochwertiges SiC-Substrat. Besonders bevorzugt ist der Polytyp 4H.

Gemäß einer weiteren günstigen Ausgestaltung hat das SiC-Substrat eine Kristallstruktur mit einer bezogen auf die Flächennormale der Gesamt-Hauptoberfläche geringfügig verkippten Orientierung (= off-Orientierung), wobei ein Verkippungswinkel im Bereich zwischen 0° und 8°, vorzugsweise bei etwa 4°, liegt. Insbesondere entspricht die Flächennormale der Gesamt-Hauptoberfläche zumindest im Wesentlichen der Wachstumsrichtung des SiC-Volumeneinkristalls, aus dem das SiC-Substrat hergestellt ist. Insbesondere ist bei der off-Orientierung die Gesamt-Hauptoberfläche des SiC-Substrats gegenüber der (0001)-Ebene der Kristallstruktur um einen Winkel im Bereich zwischen 0° und 8° in Richtung der [-1-120]-Kristallrichtung verkippt.

Gemäß einer weiteren günstigen Ausgestaltung hat das SiC-Substrat einen spezifischen elektrischen Widerstand von 8 mΩcm bis 26 mΩcm, insbesondere von 10 mΩcm bis 24 mΩcm.

Gemäß einer weiteren günstigen Ausgestaltung hat das SiC-Substrat eine Verbiegung (engl.: bow) von kleiner als 25 µm, insbesondere von kleiner als 15 µm.

Gemäß einer weiteren günstigen Ausgestaltung hat das SiC-Substrat eine Verwölbung (engl.: warp) von kleiner als 40 µm, insbesondere von kleiner als 30 µm.

Weitere Merkmale, Vorteile und Einzelheiten der Erfindung ergeben sich aus der nachfolgenden Beschreibung von Ausführungsbeispielen anhand der Zeichnung. Es zeigt:
- Fig. 1: ein Ausführungsbeispiel einer Züchtungsanordnung zur Sublimationszüchtung eines SiC-Volumeneinkristalls,
- Fig. 2: ein Ausführungsbeispiel eines zur Sublimationszüchtung üblicherweise verwendeten SiC-Keimkristalls mit KeimSchraubenversetzungen in einer Darstellung eines Längsschnitts durch den SiC-Keimkristall in Wachstumsrichtung,
- Fig. 3: ein Ausführungsbeispiel eines auf den üblichen SiC-Keimkristall gemäß Fig. 2 aufgewachsenen SiC-Volumeneinkristalls mit hoher Schraubenversetzungsdichte und mit inhomogener Schraubenversetzungsverteilung in einer Längsschnittdarstellung,
- Fig. 4: ein Ausführungsbeispiel eines auf einen gezielt und lokal begrenzt mit Nukleationszentren versehenen SiC-Keimkristall mittels der Züchtungsanordnung gemäß Fig. 1 aufgewachsenen SiC-Volumeneinkristalls mit reduzierter Schraubenversetzungsdichte und mit homogener Schraubenversetzungsverteilung in einer Längsschnittdarstellung,
- Fig. 5: den Ausschnitt V gemäß Fig. 4 mit einer vergrößerten schematischen Darstellung einer Rekombination von Schraubenversetzungen im aufwachsenden SiC-Volumeneinkristall,
- Fig. 6: ein Ausführungsbeispiel eines kombinierten Verfahrens zur röntgentopographischen Lokalisierung von Keim-Schraubenversetzungen in dem SiC-Keimkristall gemäß Fig. 2 und zur Laser-Strukturierung des SiC-Keimkristalls in Bereichen mit festgestellter erhöhter lokaler Schraubenversetzungsdichte ,
- Fig. 7: ein Ausführungsbeispiel eines mittels lokaler Beschichtung in Bereichen mit festgestellter erhöhter lokaler Schraubenversetzungsdichte strukturierten SiC-Keimkristalls,
- Fig. 8: ein Ausführungsbeispiel eines SiC-Substrats gewonnen aus einem mittels eines gezielt und lokal begrenzt mit Nukleationszentren versehenen SiC-Keimkristalls gezüchteten SiC-Volumeneinkristall mit reduzierter Schraubenversetzungsdichte und mit homogener Schraubenversetzungsverteilung in einer Draufsicht, und
- Fig. 9: ein Ausführungsbeispiel eines SiC-Substrats gewonnen aus einem mittels eines üblichen SiC-Keimkristalls gezüchteten SiC-Volumeneinkristall gemäß Fig. 3 mit hoher Schraubenversetzungsdichte und mit inhomogener Schraubenversetzungsverteilung in einer Draufsicht.

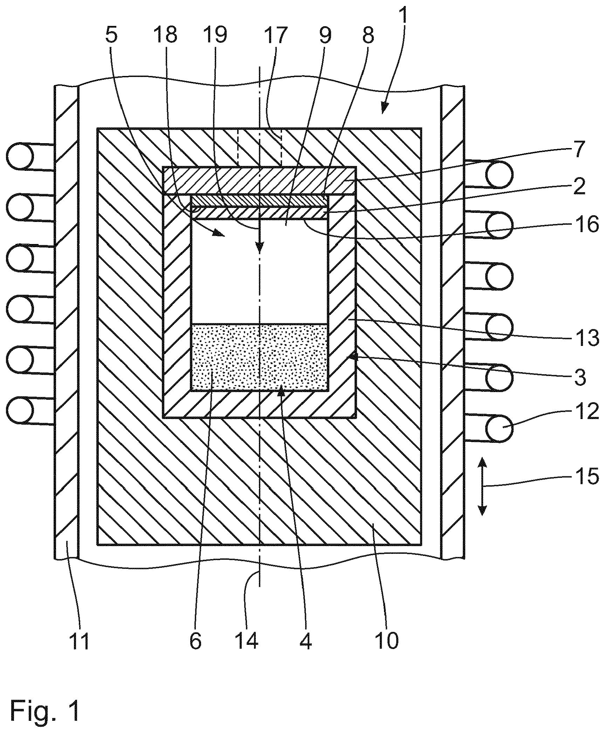

Einander entsprechende Teile sind in den Fig. 1 bis 9 mit denselben Bezugszeichen versehen. Auch Einzelheiten der im Folgenden näher erläuterten Ausführungsbeispiele können für sich genommen eine Erfindung darstellen oder Teil eines Erfindungsgegenstands sein.

In Fig. 1 ist ein Ausführungsbeispiel einer Züchtungsanordnung 1 zur Herstellung eines SiC-Volumeneinkristalls 2 mittels Sublimationszüchtung dargestellt. Die Züchtungsanordnung 1 enthält einen Züchtungstiegel 3, der einen SiC-Vorratsbereich 4 sowie einen Kristallwachstumsbereich 5 umfasst. In dem SiC-Vorratsbereich 4 befindet sich beispielsweise pulverförmiges SiC-Quellmaterial 6, das als vorgefertigtes Ausgangsmaterial vor Beginn des Züchtungsprozesses in den SiC-Vorratsbereich 4 des Züchtungstiegels 3 eingefüllt wird.

Im Bereich einer dem SiC-Vorratsbereich 4 gegenüberliegenden Tiegelstirnwand 7 des Züchtungstiegels 3 ist ein sich axial bis in den Kristallwachstumsbereich 5 erstreckender SiC-Keimkristall 8 angebracht. Der SiC-Keimkristall 8 ist insbesondere einkristallin. Die Tiegelstirnwand 7 ist beim gezeigten Ausführungsbeispiel als Tiegeldeckel des Züchtungstiegels 3 ausgebildet. Dies ist aber nicht zwingend. Auf dem SiC-Keimkristall 8 wächst der zu züchtende SiC-Volumeneinkristall 2 mittels Abscheidung aus einer sich im Kristallwachstumsbereich 5 ausbildenden SiC-Wachstumsgasphase 9 auf. Der aufwachsende SiC-Volumeneinkristall 2 und der SiC-Keimkristall 8 haben in etwa den gleichen Durchmesser. Wenn überhaupt, ergibt sich eine Abweichung von höchstens 10%, um die ein Keimdurchmesser des SiC-Keimkristalls 8 kleiner als ist ein Einkristalldurchmesser des SiC-Volumeneinkristalls 2. Allerdings kann zwischen der Innenseite einer Tiegelseitenwand 13 einerseits und dem aufwachsenden SiC-Volumeneinkristall 2 sowie dem SiC-Keimkristall 8 andererseits ein in Fig. 1 nicht gezeigter Spalt vorhanden sein.

Der Züchtungstiegel 3 inklusive des Tiegeldeckels 7 besteht bei dem Ausführungsbeispiel gemäß Fig. 1 aus einem elektrisch und thermisch leitfähigen Graphit-Tiegelmaterial mit einer Dichte von z.B. mindestens 1,75 g/cm³. Um ihn herum ist eine thermische Isolationsschicht 10 angeordnet. Letztere besteht z.B. aus einem schaumartigen Graphit-Isolationsmaterial, dessen Porosität insbesondere deutlich höher ist als die des Graphit-Tiegelmaterials.

Der thermisch isolierte Züchtungstiegel 3 ist innerhalb eines rohrförmigen Behälters 11 platziert, der beim Ausführungsbeispiel als Quarzglasrohr ausgeführt ist und einen Autoklaven oder Reaktor bildet. Zur Beheizung des Züchtungstiegels 3 ist um den Behälter 11 ist eine induktive Heizeinrichtung in Form einer Heizspule 12 angeordnet. Der Züchtungstiegel 3 wird mittels der Heizspule 12 auf die für die Züchtung erforderlichen Temperaturen erhitzt. Bei dem gezeigten Ausführungsbeispiel liegen diese Wachstumstemperaturen bei mindestens 2250°C. Die Heizspule 12 koppelt einen elektrischen Strom induktiv in die elektrisch leitfähige Tiegelseitenwand 13 des Züchtungstiegels 3 ein. Dieser elektrische Strom fließt im Wesentlichen als Kreisstrom in Umfangsrichtung innerhalb der kreis- und hohlzylindrischen Tiegelseitenwand 13 und heizt dabei den Züchtungstiegel 3 auf. Bei Bedarf kann die relative Position zwischen der Heizspule 12 und dem Züchtungstiegel 3 axial, d.h. in die Richtung einer Mittenlängsachse 14 des aufwachsenden SiC-Volumeneinkristalls 2, verändert werden, insbesondere um die Temperatur bzw. den Temperaturverlauf innerhalb des Züchtungstiegels 3 einzustellen und ggf. auch zu verändern. Die während des Züchtungsprozesses axial veränderbare Position der Heizspule 12 ist in Fig. 1 durch den Doppelpfeil 15 angedeutet. Insbesondere wird die Heizspule 12 an den Wachstumsfortschritt des aufwachsenden SiC-Volumeneinkristalls 2 angepasst verschoben. Die Verschiebung erfolgt vorzugsweise nach unten, also in Richtung des SiC-Quellmaterials 6, und bevorzugt um die gleiche Länge, um die der SiC-Volumeneinkristall 2 aufwächst, z.B. insgesamt um etwa 20 mm. Hierzu umfasst die Züchtungsanordnung 1 nicht näher gezeigte entsprechend ausgestaltete Kontroll-, Steuer- und Verstellmittel.

Die SiC-Wachstumsgasphase 9 im Kristallwachstumsbereich 5 wird durch das SiC-Quellmaterial 6 gespeist. Die SiC-Wachstumsgasphase 9 enthält zumindest Gasbestandteile in Form von Si, Si₂C und SiC₂ (= SiC-Gasspezies). Der Materialtransport vom SiC-Quellmaterial 6 zu einer Wachstumsgrenzfläche 16 am aufwachsenden SiC-Volumeneinkristall 2 erfolgt einerseits längs eines axialen Temperaturgradienten. Bei dem für die SiC-Kristallzüchtung verwendeten Sublimationsverfahren (= PVT-Verfahren) werden die Wachstumsbedingungen inklusive des Materialtransports über die im Züchtungstiegel 3 herrschenden Temperaturen eingestellt und geregelt. An der Wachstumsgrenzfläche 16 herrscht eine relativ hohe Wachstumstemperatur von mindestens 2250°C, insbesondere sogar von mindestens 2350°C oder 2400°C°. Außerdem wird an der Wachstumsgrenzfläche 16 insbesondere ein in Richtung der Mittenlängsachse 14 gemessener axialer Temperaturgradient von mindestens 5 K/cm, vorzugsweise von mindestens 15 K/cm, eingestellt. Die Temperatur innerhalb des Züchtungstiegels 3 nimmt zu dem aufwachsenden SiC-Volumeneinkristall 2 hin ab. Die höchste Temperatur liegt mit etwa 2450°C bis 2550°C im Bereich des SiC-Vorratsbereichs 4. Dieser Temperaturverlauf mit einer Temperaturdifferenz von insbesondere 100°C bis 150°C zwischen dem SiC-Vorratsbereich 4 und der der Wachstumsgrenzfläche 16 lässt sich über verschiedene Maßnahmen erreichen. So kann über eine nicht näher gezeigte Aufteilung der Heizspule 12 in zwei oder mehrere axiale Teilabschnitte eine axial variierende Beheizung vorgesehen werden. Weiterhin kann im unteren Abschnitt des Züchtungstiegels 3, z.B. durch eine entsprechende axiale Positionierung der Heizspule 12, eine stärkere Heizwirkung eingestellt werden als im oberen Abschnitt des Züchtungstiegels 3. Außerdem kann die Wärmedämmung an den beiden axialen Tiegelstirnwänden unterschiedlich ausgebildet sein. Wie in Fig. 1 schematisch angedeutet kann hierzu die thermische Isolationsschicht 10 an der unteren Tiegelstirnwand eine größere Dicke haben als an der oberen Tiegelstirnwand. Weiterhin ist es möglich, dass die thermische Isolationsschicht 10 benachbart zu der oberen Tiegelstirnwand 7, eine um die Mittenlängsachse 14 angeordnete zentrale Kühlöffnung 17 aufweist, durch die Wärme abgeführt wird. Diese zentrale Kühlöffnung 17 ist in Fig. 1 durch die gestrichelte Linien angedeutet. Außerdem herrscht in dem Züchtungstiegel 3 während der eigentlichen Kristallzüchtung ein Züchtungsdruck von insbesondere 0,1 hPa (= mbar) bis 10 hPa (= mbar).

Der SiC-Volumeneinkristall 2 wächst in einer Wachstumsrichtung 19, die im in Fig. 1 gezeigten Ausführungsbeispiel von oben nach unten, also vom Tiegeldeckel 7 hin zu dem SiC-Vorratsbereich 4, orientiert ist. Die Wachstumsrichtung 19 verläuft parallel zu der zentralen Mittenlängsachse 14. Da der aufwachsende SiC-Volumeneinkristall 2 bei dem gezeigten Ausführungsbeispiel konzentrisch innerhalb der Züchtungsanordnung 1 angeordnet ist, kann die zentrale Mittenlängsachse 14 auch der Züchtungsanordnung 1 insgesamt zugeordnet werden.

Der aufwachsende SiC-Volumeneinkristall 2 hat eine SiC-Kristallstruktur vom 4H-Polytyp. Grundsätzlich ist aber auch ein anderer Polytyp (= eine andere Kristallmodifikation), wie z.B. 6H-SiC, 3C-SiC oder 15R-SiC, möglich. Vorteilhafterweise hat der SiC-Volumeneinkristall 2 nur einen einzigen SiC-Polytyp, welcher bei dem Ausführungsbeispiel besagtes 4H-SiC ist. Der SiC-Volumeneinkristall 2 wächst mit einer hohen Modifikationsstabilität auf und hat insofern im Wesentlichen nur einen einzigen Polytyp. Letzteres ist günstig im Hinblick auf eine sehr defektarme hohe Kristallqualität.

Das mittels der Züchtungsanordnung 1 durchgeführte Züchtungsverfahren zur Herstellung des SiC-Volumeneinkristalls 2 zeichnet sich auch in anderer Hinsicht durch eine erzielte hohe Kristallqualität aus. So hat der aufwachsende SiC-Volumeneinkristall 2 eine sehr niedrige Schraubenversetzungsdichte und eine weitgehend homogene Verteilung der verbleibenden Schraubenversetzungen (TSD). Diesbezüglich ist die Beschaffenheit des SiC-Keimkristalls 8 ein wesentlicher Faktor für die Qualität des aufwachsenden SiC-Volumeneinkristalls 2.

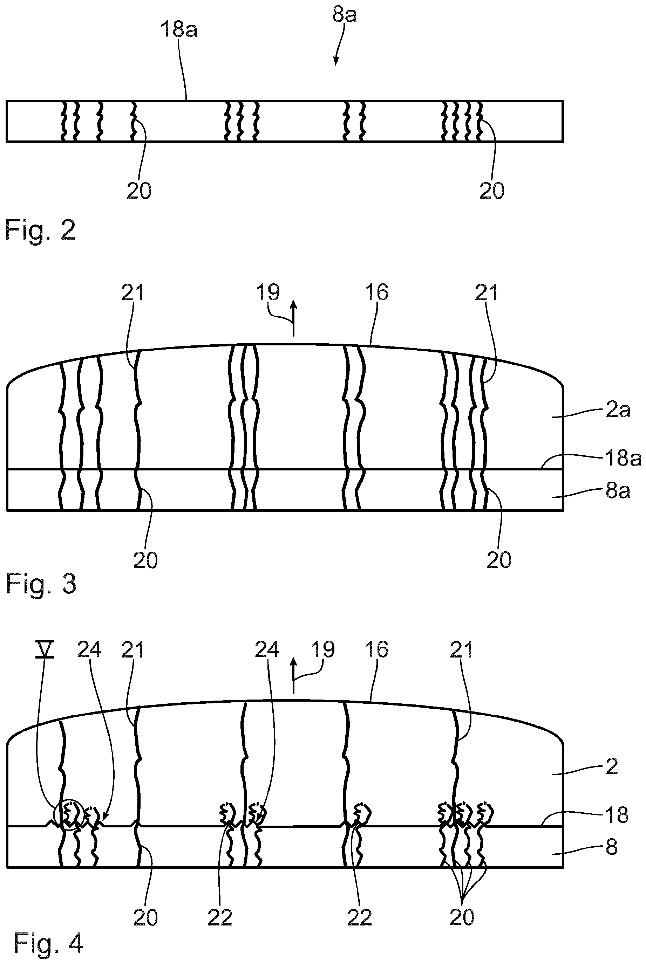

Insbesondere können sich in einem üblichen SiC-Keimkristall 8a vorhandene Keim-Schraubenversetzungen 20 (siehe Fig. 2) in Wachstumsrichtung 19 in einen aufwachsenden SiC-Volumeneinkristall 2a fortsetzen, was in der Darstellung gemäß Fig. 3 verdeutlicht ist. Die Keim-Schraubenversetzungen 20 des SiC-Keimkristalls 8a führen an einer wie üblich behandelten, also insbesondere vollständig glatt polierten, Wachstumsoberfläche 18a des SiC-Keimkristalls 8a zur Ausbildung von Volumeneinkristall-Schraubenversetzungen 21 im aufwachsenden SiC-Volumeneinkristall 2a. Insofern stellen die Volumeneinkristall-Schraubenversetzungen 21 eine (unerwünschte) Fortsetzung der Keim-Schraubenversetzungen 20 dar.

Um letzteres nach Möglichkeit zu verhindern, wird der SiC-Keimkristall 8 vor seinem Einsatz zur Züchtung des SiC-Volumeneinkristalls 2 einer besonderen zweistufigen Behandlung unterzogen.

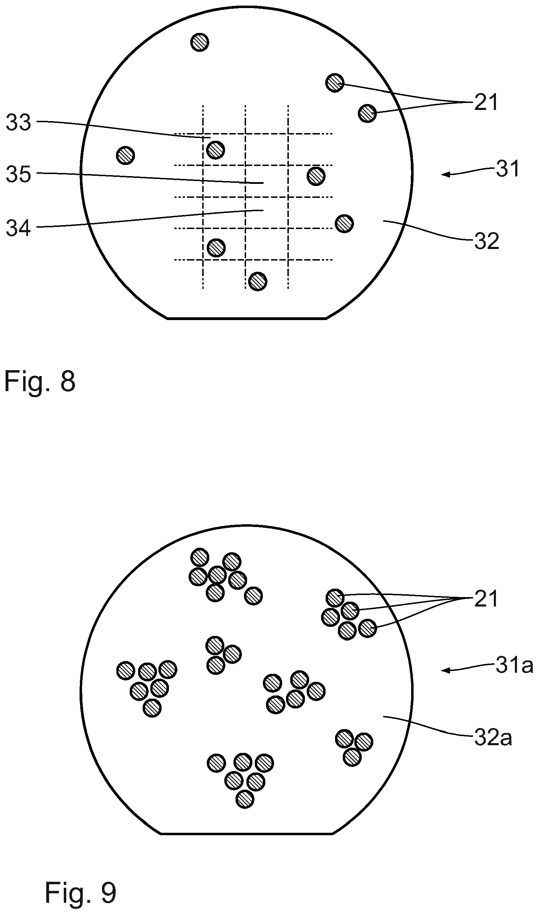

Zum einen wird als erste Behandlungsstufe eine Keim-Schraubenversetzungsuntersuchung durchgeführt, im Rahmen derer eine Wachstumsoberfläche 18 des SiC-Keimkristalls 8 segmentweise (und insbesondere mit einer Segmentierung vergleichbar oder ähnlich zu der in Fig. 8 im Zusammenhang mit einem SiC-Substrat schematisch mit angedeuteten Segmentierung) auf das Vorhandensein von Keim-Schraubenversetzungen 20 untersucht wird. Dabei werden insbesondere auch eine Verteilung dieser Keim-Schraubenversetzungen 20 sowie eine über die gesamte Wachstumsoberfläche 18 hinweg ermittelte Schraubenversetzungs-Keimgesamtdichte und/oder mehrere lokale Schraubenversetzungs-Keimsegmentdichten, die sich jeweils nur auf ein bestimmtes jeweils etwa 10 mm² großes Keimsegment der Wachstumsoberfläche 18 beziehen, bestimmt. Die Keimsegmente, an denen eine erhöhte lokale Schraubenversetzungs-Keimsegmentdichte festgestellt worden ist, können insbesondere markiert werden. Erhöht ist eine lokale Schraubenversetzungs-Keimsegmentdichte, wenn ihr Wert mindestens doppelt so groß ist wie der Wert der Schraubenversetzungs-Keimgesamtdichte, also um mindestens einen Faktor von 2 größer ist.

Zum anderen wird als zweite Behandlungsstufe eine Oberflächenbearbeitung durchgeführt, im Rahmen derer die Wachstumsoberfläche 18 im Bereich von Keimsegmenten mit festgestellter erhöhter lokaler Schraubenversetzungs-Keimsegmentdichte jeweils mit Nukleationszentren 22 versehen werden.

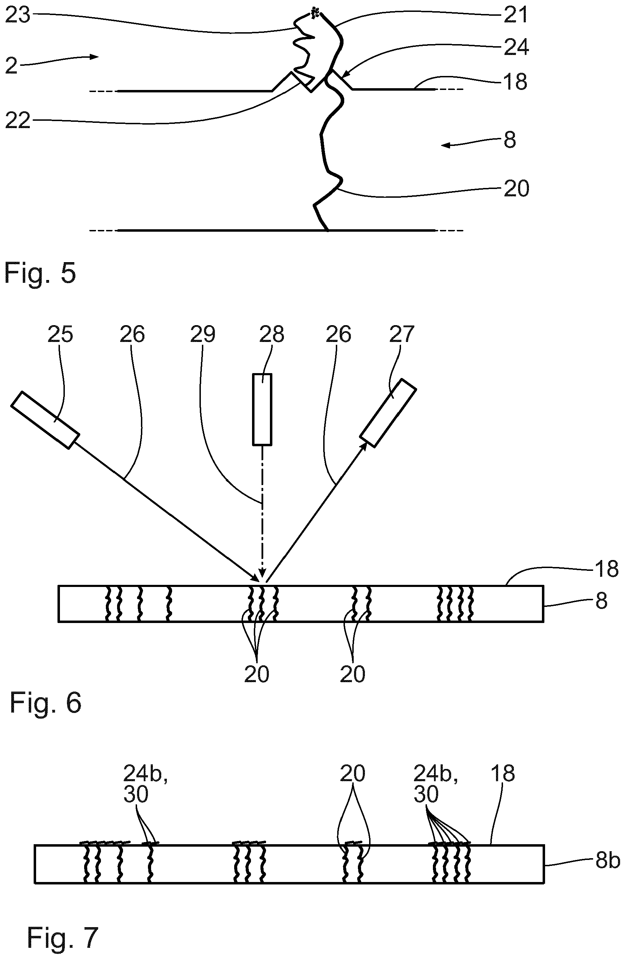

Jedes dieser Nukleationszentren 22 kann während der eigentlichen Sublimationszüchtung des SiC-Volumeneinkristalls 2 als Ausgangspunkt einer Kompensations-Schraubenversetzung 23 dienen. Eine solche während der eigentlichen Sublimationszüchtung von einem gezielt platzierten Nukleationszentrum 22 ausgehende Kompensations-Schraubenversetzung 23 kann mit der sich am Ort des Nukleationszentrums 22 aus dem SiC-Keimkristall 8 fortsetzenden Volumeneinkristall-Schraubenversetzung 21 rekombinieren (siehe Fig. 4 sowie vergrößerte Detaildarstellung gemäß Fig. 5). Die aus dem SiC-Keimkristall 8 stammende und sich eigentlich im SiC-Volumeneinkristall 2 fortsetzende Volumeneinkristall-Schraubenversetzung 21 und die Kompensations-Schraubenversetzung 23 löschen sich vorteilhafterweise gegenseitig aus. Dadurch resultieren im aufwachsenden SiC-Volumeneinkristall 2 - und auch in daraus erzeugten für die Bauelementeherstellung bestimmten scheibenförmigen einkristallinen SiC-Substraten 31 (siehe Fig. 8) - eine Reduzierung der Schraubenversetzungsdichte sowie eine Homogenisierung der Verteilung der verbleibenden Volumeneinkristall-Schraubenversetzung 21.

Die Erzeugung der günstigen Nukleationszentren 22 erfolgt durch eine lokal begrenzte Strukturierung der Wachstumsoberfläche 18, insbesondere in den Keimsegmenten mit festgestellter erhöhter lokaler Schraubenversetzungs-Keimsegmentdichte. Die Wachstumsoberfläche 18 wird gezielt und lokal begrenzt mit Nukleationsstrukturen 24 versehen, die gemäß dem in Fig. 4 und 5 gezeigten Ausführungsbeispiel als aufgeraute Oberflächenbereiche ausgestaltet sind. Andere Ausgestaltungen der Nukleationsstrukturen 24 sind aber ebenfalls möglich, beispielsweise lokal begrenzt polierte, geäzte und/oder beschichtete Oberflächenbereiche. Die in Fig. 4 und 5 gezeigten Nukleationsstrukturen 24 in Form von aufgerauten Oberflächenbereichen an der Wachstumsoberfläche 18 des SiC-Keimkristalls 8 lassen sich beispielsweise mittels einer Laserstrahlung erzeugen.

Es hat sich gezeigt, dass eine lokal begrenzte Strukturierung der Wachstumsoberfläche 18 zu deutlich besseren Ergebnissen im Hinblick auf die gewünschte Reduzierung der Schraubenversetzungsdichte und Homogenisierung der Schraubenversetzungsverteilung im aufwachsenden SiC-Volumeneinkristall 2 führt als bei einer durchgängigen Strukturierung der Wachstumsoberfläche 18.

Die Keim-Schraubenversetzungsuntersuchung als erste Behandlungsstufe eine und die Oberflächenbearbeitung als zweite Behandlungsstufe können grundsätzlich zeitlich nacheinander und ggf. auch mit separaten Anlagen vorgenommen werden. Besonders effizient ist aber das in Fig. 6 gezeigte Ausführungsbeispiel einer kombinierten und insbesondere gleichzeitigen Durchführung dieser beiden Behandlungsstufen. Dabei wird die Keim-Schraubenversetzungsuntersuchung röntgentopographisch durchgeführt. Eine Röntgenquelle 25 sendet Röntgenstrahlung 26 in Richtung der Wachstumsoberfläche 18 und tastet die Wachstumsoberfläche 18 mit dieser Röntgenstrahlung 26 sukzessive und insbesondere vollständig ab. Ein Röntgendetektor 27 empfängt die von der Wachstumsoberfläche 18 reflektierte Röntgenstrahlung 26 und wandelt sie in ein Empfangssignal um, das dann einer (nicht dargestellten) Auswerteeinheit zur weiteren Auswertung, ob an der aktuellen Reflektionsstelle der Röntgenstrahlung 26 an der Wachstumsoberfläche 18 eine Keim-Schraubenversetzung 20 vorliegt, zugeführt wird. Zeigt sich bei dieser Auswertung, dass in dem gerade untersuchten Keimsegment eine relevante erhöhte lokale Schraubenversetzungs-Keimsegmentdichte gegeben ist, wird ein Laserschreiber 28 angesteuert und dazu veranlasst, dieses Keimsegment der Wachstumsoberfläche 18 mittels einer Laserstrahlung 29 zu bearbeiten und dort eine Nukleationsstruktur 24 mit Nukleationszentren 22 zu erzeugen.

In Fig. 7 ist ein Ausführungsbeispiel eines SiC-Keimkristalls 8b mit anderen Nukleationsstrukturen 24b an seiner Wachstumsoberfläche 18b gezeigt. Letztere sind ebenfalls lokal begrenzt und in Keimsegmenten der Wachstumsoberfläche 18b mit festgestellter erhöhter lokaler Schraubenversetzungs-Keimsegmentdichte platziert. Zur Erzeugung dieser Nukleationsstrukturen 24b wird die Wachstumsoberfläche 18b in den maßgeblichen Keimsegmenten lithographisch nano-strukturiert, bei dem Ausführungsbeispiel gemäß Fig. 7 mit einer Kohlenstoffbeschichtung 30 versehen.

Die Züchtungsanordnung 1 ermöglicht bei Verwendung eines der SiC-Keimkristalle 8, 8b mit geeigneter lokal begrenzter Oberflächenstrukturierung die Züchtung eines hochqualitativen SiC-Volumeneinkristalls 2, der nur wenige Volumeneinkristall-Schraubenversetzungen 21 und die in einer sehr homogenen lateralen Verteilung hat.

Aus diesen qualitativ hochwertigen SiC-Volumeneinkristallen 2 können dann ebenso hochwertige SiC-Substrate 31 (siehe schematischen Darstellung gemäß Fig. 8) hergestellt werden. Diese scheibenförmigen SiC-Substrate 31 werden aus dem betreffenden SiC-Volumeneinkristall 2 dadurch gewonnen, dass sie axial sukzessive als Scheiben senkrecht zur Wachstumsrichtung 19 bzw. zur Mittenlängsachse 14 abgeschnitten bzw. abgesägt werden. Ein derartiges SiC-Substrat 31 ist groß und dünn. In einer möglichen Ausführungsform hat seine Gesamt-Hauptoberfläche 32 einen Substratdurchmesser von mindestens 150 mm, beispielsweise von 200 mm, wohingegen eine Substratdicke bei etwa 500 µm liegt. Das SiC-Substrat 31 hat ebenso wie der SiC-Volumeneinkristall 2, aus dem es hergestellt ist, eine niedrige Schraubenversetzungs-Gesamtdichte von vorzugsweise höchstens 1000 cm⁻² und eine sehr homogene Verteilung der verbliebenen Volumeneinkristall-Schraubenversetzungen 21. Beides verbessert die Eignung des SiC-Substrats 31 für einen Einsatz in der Bauelementeherstellung. Die Schraubenversetzungs-Gesamtdichte bezieht sich bei dem SiC-Volumeneinkristall 2 auf eine komplette Querschnittsfläche des SiC-Volumeneinkristalls 2 senkrecht zur Mittenlängsachse 14 oder zur Wachstumsrichtung 19 und bei dem SiC-Substrat 31 auf die komplette Gesamt-Hauptoberfläche 32. Bei dem SiC-Substrat 31 wird sie hier auch als Schraubenversetzungs-Substratgesamtdichte bezeichnet. Die sehr homogene Schraubenversetzungsverteilung geht aus der Abbildung gemäß Fig. 8 hervor, in der die Si-Seite des SiC-Substrats 31 gezeigt ist.

In Fig. 8 ist durch gestrichelte Linien auch eine (fiktive) Ein- bzw. Aufteilung der Gesamt-Hauptoberfläche 32 in Substratsegmente 33 veranschaulicht, wobei die Substratsegmente 33 zumindest, soweit sie keinen Bezug zu dem Substratrand haben, jeweils quadratisch sind und eine Substratsegmentfläche von insbesondere 10 mm² haben. Jedes Substratsegment 33 hat eine lokale Schraubenversetzungs-Substratsegmentdichte, die die Anzahl der in ihm vorhandenen Volumeneinkristall-Schraubenversetzungen 21 bezogen auf seine Substratsegmentfläche angibt. Bezogen auf das SiC-Substrat 31 können die Volumeneinkristall-Schraubenversetzungen 21 auch als Substrat-Schraubenversetzungen 21 verstanden und bezeichnet werden. Innerhalb einer 85%-igen Teilfläche der Gesamt-Hauptoberfläche 32 haben die Substratsegmente 33 eine lokale Schraubenversetzungs-Substratsegmentdichte, die jeweils um höchstens 25 % von der Schraubenversetzungs-Substratgesamtdichte abweicht. Die wenigen Substrat-Schraubenversetzungen 21 sind also auch sehr homogen verteilt. Letzteres wird zusätzlich auch dadurch erreicht, dass sich beliebige benachbarte Substratsegmente 34 und 35 innerhalb dieser Teilfläche in ihren jeweiligen lokalen Schraubenversetzungs-Substratsegmentdichten um höchstens 25 % voneinander unterscheiden.

Zum Vergleich ist in Fig. 9 ebenfalls die Si-Seite eines üblichen SiC-Substrats 31a dargestellt, das aus einem mittels eines üblichen SiC-Keimkristalls 8a ohne lokal begrenzte Oberflächenstrukturierungen gezüchteten SiC-Volumeneinkristall 2a (siehe Fig. 3) hergestellt ist. Die höhere Schraubenversetzungs-Gesamtdichte sowie die über die Gesamt-Hauptoberfläche 32a inhomogenere Schraubenversetzungsverteilung sind der schematischen Darstellung gemäß Fig. 9 zu entnehmen.

## Patentansprüche

1. Verfahren zur Herstellung mindestens eines SiC-Volumeneinkristalls (2) mittels einer Sublimationszüchtung, wobei
a) vor Züchtungsbeginn
a1) in einem Kristallwachstumsbereich (5) eines Züchtungstiegels (3) ein SiC-Keimkristall (8, 8b) mit einer Wachstumsoberfläche (18, 18b) angeordnet wird und
a2) in einen SiC-Vorratsbereich (4) des Züchtungstiegels (3) SiC-Quellmaterial (6) eingebracht wird, und
b) während der Züchtung bei einer Züchtungstemperatur von bis zu 2400°C und einem Züchtungsdruck zwischen 0,1 mbar und 100 mbar mittels Sublimation des SiC-Quellmaterials (6) und mittels Transport der sublimierten gasförmigen Komponenten in den Kristallwachstumsbereich (5) dort eine SiC-Wachstumsgasphase (9) erzeugt wird, in der mittels Abscheidung aus der SiC-Wachstumsgasphase (9) auf dem SiC-Keimkristall (8, 8b) ein SiC-Volumeneinkristall (2) aufwächst,
**dadurch gekennzeichnet, dass**
c) der SiC-Keimkristall (8, 8b) vor Züchtungsbeginn an der Wachstumsoberfläche (18, 18b)
c1) auf das Vorhandensein von Keim-Schraubenversetzungen (20) untersucht wird, wobei die Wachstumsoberfläche (18, 18b) in Keimsegmente aufgeteilt wird und für jedes Keimsegment eine zugehörige lokale Schraubenversetzungs-Keimsegmentdichte ermittelt wird, und
c2) bearbeitet wird, so dass in jedem Keimsegment, dessen lokale Schraubenversetzungs-Keimsegmentdichte um mindestens einen Faktor von 1,5 bis 4 über einer für die gesamte Wachstumsoberfläche (18, 18b) ermittelten Schraubenversetzungs-Keimgesamtdichte liegt, Nukleationszentren (22) generiert werden, wobei die Nukleationszentren (22) während der danach durchgeführten Züchtung Ausgangspunkte für jeweils mindestens eine Kompensations-Schraubenversetzung (23) sind.

2. Verfahren nach Anspruch 1, **dadurch gekennzeichnet, dass** in einem Keimsegment mit festgestellter erhöhter lokaler Schraubenversetzungs-Keimsegmentdichte eine Nukleations-Anzahl an Nukleationszentren (22) generiert wird, welche mindestens halb so groß ist wie eine Versetzungs-Anzahl an in diesem Keimsegment ermittelten Keim-Schraubenversetzungen (20).

3. Verfahren nach Anspruch 1 oder 2, **dadurch gekennzeichnet, dass** die Nukleationszentren (22) durch eine lokal begrenzte Strukturierung der Wachstumsoberfläche (18, 18b) generiert werden.

4. Verfahren nach einem der vorhergehenden Ansprüche, **dadurch gekennzeichnet, dass** die Nukleationszentren (22) durch eine lokal begrenzte Bearbeitung der Wachstumsoberfläche (18, 18b) mit einer Laserstrahlung (29) generiert werden.

5. Verfahren nach einem der vorhergehenden Ansprüche, **dadurch gekennzeichnet, dass** die Nukleationszentren (22) durch eine lokal begrenzte Beschichtung (30) der Wachstumsoberfläche (18b) mit einem Zusatzstoff generiert werden.

6. Verfahren nach einem der vorhergehenden Ansprüche, **dadurch gekennzeichnet, dass** die Nukleationszentren (22) durch ein lokal begrenztes Polieren der Wachstumsoberfläche (18, 18b) generiert werden.

7. Verfahren nach einem der vorhergehenden Ansprüche, **dadurch gekennzeichnet, dass** die Nukleationszentren (22) durch ein lokal begrenztes Ätzen der Wachstumsoberfläche (18, 18b) generiert werden.

8. Verfahren nach einem der vorhergehenden Ansprüche, **dadurch gekennzeichnet, dass** zur Generierung der Nukleationszentren (22) an der Wachstumsoberfläche (18, 18b) des SiC-Keimkristalls (8, 8b) mindestens eine Nano-Struktur erzeugt wird.

9. Verfahren nach einem der vorhergehenden Ansprüche, **dadurch gekennzeichnet, dass** die Untersuchung auf Keim-Schraubenversetzungen (20) röntgentopographisch durchgeführt wird.

10. Verfahren nach einem der vorhergehenden Ansprüche, **dadurch gekennzeichnet, dass** die Untersuchung auf Keim-Schraubenversetzungen (20) und die Bearbeitung der Wachstumsoberfläche (18, 18b) des SiC-Keimkristalls (8, 8b) zur Generierung der Nukleationszentren (22) in einem kombinierten Verfahren durchgeführt werden.

11. Einkristallines SiC-Substrat (31) hergestellt aus einem sublimationsgezüchteten SiC-Volumeneinkristall (2) mit einer Gesamt-Hauptoberfläche (32), wobei
a) die Gesamt-Hauptoberfläche (32) fiktiv in Substratsegmente (33) mit einer jeweils zugehörigen Substratsegmentfläche aufgeteilt ist, wobei jedes Substratsegment (33) eine lokale Schraubenversetzungs-Substratsegmentdichte hat, die die Anzahl der in diesem Substratsegment (33) vorhandenen Substrat-Schraubenversetzungen (21) bezogen auf die Substratsegmentfläche dieses Substratsegments angibt,
b) das SiC-Substrat (31) eine für die Gesamt-Hauptoberfläche insgesamt (32) geltende Schraubenversetzungs-Substratgesamtdichte aufweist, und
c) das SiC-Substrat (31) eine durch mindestens 85 % der Gesamt-Hauptoberfläche (32) gebildete Teilfläche aufweist, wobei die lokalen Schraubenversetzungs-Substratsegmentdichten aller innerhalb der Teilfläche liegenden Substratsegmente (33, 34, 35) um höchstens 25 % von der Schraubenversetzungs-Substratgesamtdichte abweichen.

12. SiC-Substrat nach Anspruch 11, **dadurch gekennzeichnet, dass** die lokalen Schraubenversetzungs-Substratsegmentdichten aller innerhalb der Teilfläche liegenden Substratsegmente (33, 34, 35) um höchstens 20 %, insbesondere um höchstens 15 %, von der Schraubenversetzungs-Substratgesamtdichte abweichen.

13. SiC-Substrat nach Anspruch 11 oder 12, **dadurch gekennzeichnet, dass** die Teilfläche eine Größe von mindestens 90 % der Gesamt-Hauptoberfläche (32) hat.

14. SiC-Substrat nach einem der Ansprüche 11 bis 13, **dadurch gekennzeichnet, dass** die Schraubenversetzungs-Substratgesamtdichte des SiC-Substrats (31) höchstens 1000 cm⁻², insbesondere höchstens 500 cm⁻² beträgt.

15. SiC-Substrat nach einem der Ansprüche 11 bis 14, **dadurch gekennzeichnet, dass** sich die Schraubenversetzungs-Substratsegmentdichten zweier beliebiger innerhalb der Teilfläche liegender und zueinander benachbarter Substratsegmente (34, 35) um höchstens 25 %, insbesondere um höchstens 20 % und vorzugsweise um höchstens 15 %, voneinander unterscheiden.
